# FASCICULE DE BREVET EUROPEEN

(11) **EP 4 026 407 B1**
(45) Date de publication et mention de la délivrance du brevet: **05.06.2024**
(21) Numéro de dépôt: 20761297.9
(22) Date de dépôt: 31.08.2020
(51) Int. Cl.: H05K 3/32, H05K 5/00

(54) **ENSEMBLE D'UNE CARTE, D'UN COMPOSANT ELECTRIQUE ET D'UN CONNECTEUR ELECTRIQUE**
ANORDNUNG MIT EINER KARTE, EINEM ELEKTRISCHEN BAUELEMENT UND EINEM ELEKTRISCHEN STECKVERBINDER
ASSEMBLY COMPRISING A CARD, AN ELECTRICAL COMPONENT AND AN ELECTRICAL CONNECTOR

(30) Priorité: 06.09.2019 FR 1909840
(43) Date de publication de la demande: 13.07.2022
(73) Titulaire: Valeo eAutomotive France SAS, 95800 Cergy (FR)
(72) Inventeur: POUILLY, Aurélien, 78300 POISSY (FR); LEGENDRE, Alexandre, 95280 JOUY-LE-MOUTIER (FR)
(74) Mandataire: Valeo Powertrain Systems
(86) Numéro de dépôt international: PCT/EP2020/074246
(87) Numéro de publication internationale: WO 2021/043727

(56) Documents cités:
- EP-A1- 3 240 159
- US-A1- 2016 374 201
- US-A1- 2019 229 445

## Description

### DOMAINE TECHNIQUE

La présente invention concerne le domaine des équipements électriques, notamment pour des applications en électronique de puissance dans le domaine automobile, comme des onduleurs, des convertisseurs de tension DC/DC ou des chargeurs électriques (OBC pour On-Board Charger en anglais).

Plus précisément, l'invention concerne un ensemble électrique comprenant une carte électronique, un connecteur électrique et un composant électrique, notamment un composant électronique de puissance, tel qu'un transformateur électrique.

### ETAT DE LA TECHNIQUE

En électronique de puissance, notamment dans les onduleurs, les convertisseurs de tension DC/DC ou les chargeurs électriques, il est souvent nécessaire de fixer et de connecter un composant électrique lourd, tel qu'un transformateur électrique apte à transférer plusieurs kilowatts de puissance, sur une carte électronique (PCB pour Printed Circuit Board an anglais).

Pour transférer de telles puissances de plusieurs de kilowatts, autrement dit de forts courants supérieurs à 18 A ou de fortes tensions supérieures à 400 V, on doit connecter sur des pistes électriques de la carte électronique des composants électroniques comportant des conducteurs électriques, notamment cylindriques, tels que des conducteurs électriques de connexion par exemple, notamment d'environ 2 mm de diamètre.

A cette fin, selon l'état de la technique, on réalise des trous dans la carte électronique, d'un diamètre légèrement supérieur à celui des conducteurs électriques de connexion ; par exemple, dans l'exemple donné ci-dessus, on réalise des trous d'environ 2,3 mm de diamètre.

Ensuite, on passe les conducteurs électriques de connexion dans de tels trous respectifs réalisés dans la carte électronique, de sorte à positionner correctement lesdits conducteurs électriques de connexion par rapport à la piste électrique de la carte électronique, puis on réalise une brasure. Ces opérations de positionnement du composant électrique et des conducteurs électriques de connexion, ainsi que le passage desdits conducteurs électriques de connexion dans les trous, sont généralement réalisées de façon manuelle ou lors d'opérations automatiques spécifiques. EP 3 240 159 A1 divulgue une barre de connexion électrique.

Dans ce contexte, la présente invention concerne la problématique de l'amélioration, de la simplification et de la fiabilisation du montage de composants électriques, notamment de composants électriques « lourds », sur une carte électronique.

### PRESENTATION DE L'INVENTION

A cette effet, l'invention vise un ensemble électrique comprenant une carte électronique, au moins un connecteur électrique et un composant électrique, ledit connecteur électrique étant rapporté sur la carte électronique pour y connecter le composant électrique, le connecteur électrique comprenant une partie de montage et une partie de connexion, le composant électrique comprenant au moins un conducteur électrique de connexion dont une extrémité est connectée à une partie active du composant électrique et l'autre extrémité est libre et destinée à être connectée au connecteur électrique, la carte électronique ayant une ouverture de passage permettant le passage d'une partie du conducteur électrique de connexion comprenant l'extrémité libre et de la partie de connexion du connecteur électrique, ledit conducteur électrique de connexion s'étendant et traversant l'ouverture de passage suivant un axe réel présentant, par rapport à un axe nominal selon lequel ledit conducteur électrique de connexion est supposé s'étendre, une déviation axiale inférieure à une déviation axiale maximale prédéterminée, la partie de connexion du connecteur électrique présentant une surface de connexion configurée pour recevoir l'extrémité libre du conducteur électrique de connexion, la surface de connexion ayant une largeur supérieure à un décalage maximal de l'extrémité libre du conducteur électrique de connexion correspondant à ladite déviation axiale maximale prédéterminée du conducteur électrique de connexion.

Grâce à l'invention, notamment, le montage automatique de composants électriques lourds est réalisé plus rapidement et de façon sécurisée, fiable, sans rebus et à moindre coût.

Selon un mode de réalisation, le connecteur électrique présente une section formant un angle droit et comprend une partie de montage, correspondant à ladite partie de montage, parallèle à la carte électronique et une partie de connexion orthogonale au plan de la carte électronique, ledit connecteur électrique étant rapporté sur la carte électronique de telle sorte que la partie de montage se trouve d'un côté de la carte électronique, du même côté que la partie active du composant électrique ou de l'autre côté, et la partie de connexion traverse la carte électronique via l'ouverture de passage, la connexion entre l'extrémité libre du conducteur électrique de connexion et la surface de connexion de la partie de connexion étant destinée à être réalisée du côté opposé de la carte électronique.

Selon un mode de réalisation, le conducteur électrique de connexion est brasé sur la surface de connexion du connecteur électrique.

Selon un mode de réalisation, le composant électrique est un transformateur électrique.

Selon un mode de réalisation, ledit transformateur électrique est adapté pour transformer une haute tension, supérieure à 400 V, en une basse tension, inférieure à 100 V.

Selon un mode de réalisation, ledit connecteur électrique est adapté pour recevoir la connexion du conducteur électrique de connexion, ledit conducteur électrique de connexion étant destiné à transférer une haute tension, supérieure à 300 V.

Selon un mode de réalisation, le composant électrique est une capacité chimique.

Selon un mode de réalisation, la carte électronique est une carte de commande d'un équipement électrique.

Selon un mode de réalisation, l'ensemble électrique comprenant au moins deux connecteurs électriques, la carte électronique comporte une unique ouverture de passage permettant le passage d'au moins deux conducteurs électriques de connexion du composant électrique et des au moins deux parties de connexion correspondantes.

Selon un mode de réalisation, l'ensemble électrique comprenant au moins deux connecteurs électriques, la carte électronique comporte au moins deux ouvertures de passage permettant respectivement le passage d'un conducteur électrique de connexion du composant électrique et d'une partie de connexion correspondante d'un connecteur électrique, le nombre d'ouvertures de passage étant adapté au nombre de paires formées d'un conducteur électrique de connexion et d'un connecteur électrique.

Selon un mode de réalisation, l'ensemble électrique présente un espacement entre ouvertures de passage supérieur à une distance d'isolation électrique de sécurité prédéfinie.

La présente invention vise aussi un équipement électrique comprenant un ensemble électrique tel que brièvement décrit ci-dessus.

Notamment, ledit équipement électrique est un convertisseur de tension DC/DC ou un onduleur ou un chargeur électrique.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
Fig. 1 est une représentation schématique d'un ensemble d'une carte électronique selon un exemple de l'invention ;
Fig. 2 est une représentation schématique de l'autre côté du même ensemble, avec des composants électriques connectés à la carte électronique via les connecteurs électriques ;
Fig. 3 est une représentation schématique, en vue rapprochée, de l'un desdits composants électriques ;
Fig. 4 est une représentation schématique de la connexion entre des conducteurs électriques de connexion de composants électriques, dont la partie active est volontairement omise, avec des connecteurs électriques, selon un exemple de l'invention ;
Fig. 5 est une représentation schématique de connecteurs électriques pour un exemple d'ensemble électrique selon l'invention ;
Fig. 6 est une représentation schématique de la connexion entre d'un conducteur électrique de connexion d'un composant électrique, dont la partie active est omise, avec un connecteur électrique, selon un exemple de l'invention ;
Fig. 7 est une représentation schématique d'un autre exemple d'ensemble électrique selon l'invention, avec plusieurs ouvertures de passage.

Il faut noter que les figures exposent l'invention de manière détaillée pour permettre de mettre en oeuvre l'invention, lesdites figures pouvant bien entendu servir à mieux définir l'invention le cas échéant.

### DESCRIPTION DETAILLEE DE L'INVENTION

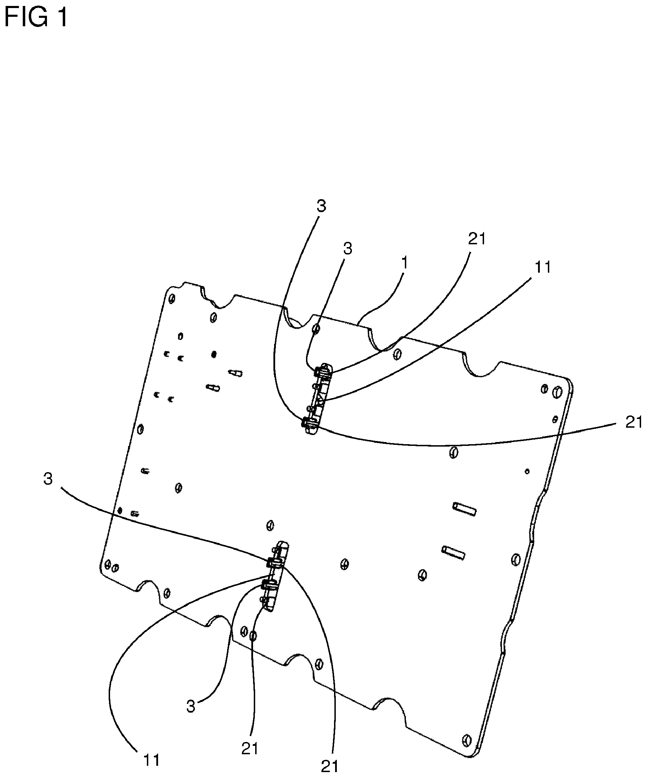

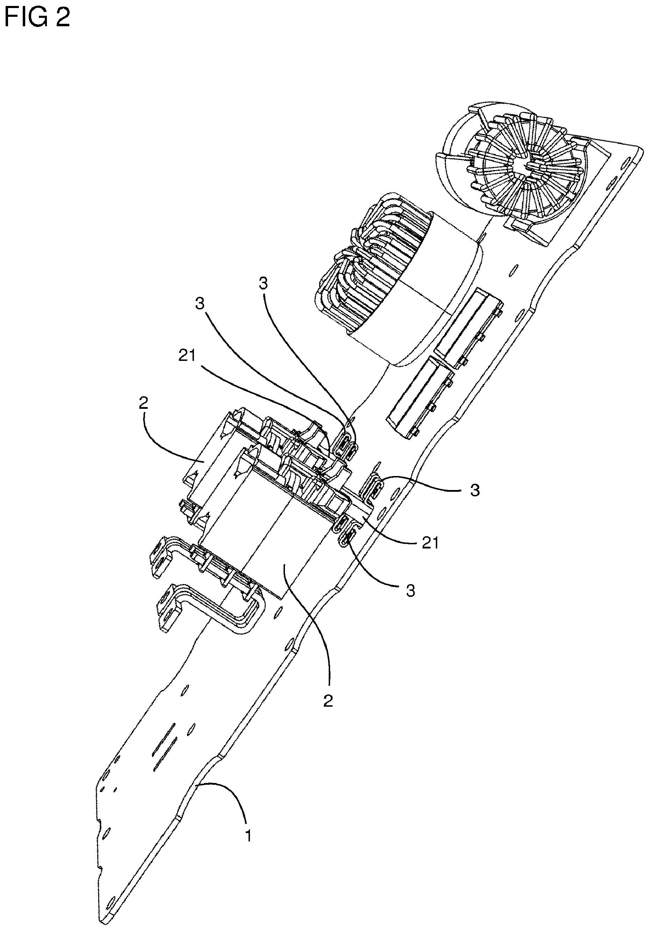

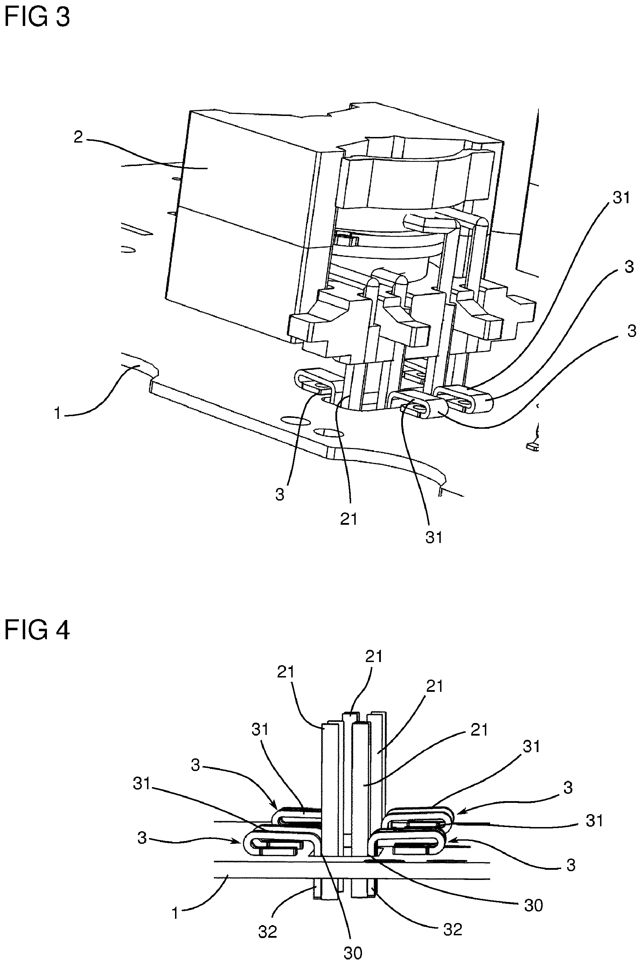

La figure 1 montre une carte électronique 1 avec deux ouvertures de passage 11. Conformément à l'invention, des connecteurs électriques 3, qui seront décrits en détail ci-après, sont engagés dans les ouvertures de passage 11. Des conducteurs électriques de connexion 21 sont brasés sur les connecteurs électriques 3. Ainsi, d'un côté (non visible sur la figure 1 mais visible sur les figures 2 et 3 notamment) de la carte électronique 1, on a la partie active d'au moins un composant électrique, notamment lourd, disposé sur une ou plusieurs parties de montage de connecteurs électriques 3. De l'autre côté, visibles sur la figure 1, des conducteurs électriques de connexion 21 de ces composants électriques, ayant traversé la carte électronique 1, de même que des parties de connexion des connecteurs électriques 3, sont brasés sur lesdites parties de connexion des connecteurs électriques 3.

Comme cela est visible sur la figure 2 et sur la figure 3, un ou plusieurs composants électriques 2, notamment des transformateurs électriques ou des capacités chimiques, sont reçus respectivement sur un ou plusieurs connecteurs électriques 3, d'un côté de la carte électronique 1. Les connecteurs électriques 3 sont notamment déposées sur la carte électronique 1 par un procédé de dépôt CMS, signifiant Composant Monté en Surface, selon un procédé connu de l'homme du métier. Les connecteurs électriques 3 sont ensuite brasés sur la carte électronique 1.

La présente invention vise l'ensemble électrique formé par une carte électronique 1, au moins un composant électrique 2 et au moins un connecteur électrique 3 rapporté sur ladite carte électronique 1 et configuré pour connecter ledit composant électrique 2 à ladite carte électronique 1.

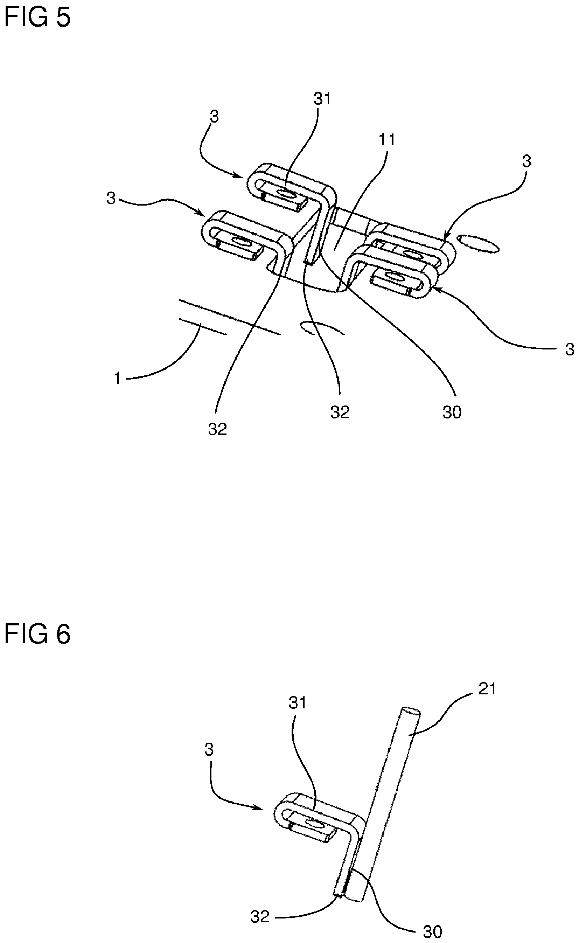

Les connecteurs électriques 3 sont mieux visibles sur les figures 5 et 6. Notamment, la partie de montage 31 peut présenter une forme en spirale ouverte pour augmenter sa souplesse et améliorer sa tenue mécanique. Par exemple, la partie de montage 31 est formé d'une lame repliée sur elle-même en deux plans parallèles, et parallèles à la surface de la carte électronique 1. Le plan le plus éloigné de la surface de la carte électronique 1 forme un plan de montage recevant le composant électrique 2. La brasure des connecteurs électriques 3 sur la carte électronique 1 assure aussi leur maintien mécanique pour éviter tout arrachement desdits connecteurs électriques 3.

La forme des connecteurs électriques 3 est en outre configurée de sorte à assurer une position stable du composant électrique 2 lors du montage, celui-ci étant « suspendu » avant la brasure. Ainsi, le composant électrique 2 repose sur le plan de montage de la partie de montage des connecteurs électriques 3, puis la brasure des conducteurs électriques de connexion 21 sur les parties de connexion des connecteurs électriques 3 renforce la stabilité de l'ensemble électrique.

Notamment, la partie de connexion 32 peut avoir une forme plane et être orthogonale à la partie de montage 31.

Comme le montrent notamment les figures 4 et 6, la partie de connexion 32 présente une surface de connexion 30 à laquelle est connecté par brasure le conducteur électrique de connexion 21 du composant électrique 2.

Comme indiqué précédemment, il est connu que, dans l'état de la technique, pour un composant électrique 2 tel qu'un transformateur électrique, les conducteurs électriques de connexion 21 utilisés pour connecter ledit composant électrique 2 à une carte électronique ont un diamètre de l'ordre de 2 mm. Pour réaliser la connexion dudit composant électrique 2 sur ladite carte électronique, des trous de passage ayant un diamètre de l'ordre de 2,4 mm sont réalisés sur la carte électronique. Les conducteurs électriques de connexion 21 sont engagés dans ces trous de passage et brasés sur une piste électrique située du côté de la carte électronique opposé à la partie active du composant électrique 2.

Ce procédé connu nécessite une grande précision de placement du composant électrique 2 et des conducteurs électriques de connexion 21 pour permettre le passage desdits conducteurs électriques de connexion 21 dans les trous de passage correspondants. Les tolérances de fabrication et de positionnement de ces conducteurs électriques de connexion 21 sont par conséquents très réduites, dans l'état de l'art.

En outre, ce procédé connu impose que lesdits conducteurs électriques de connexion 21 ne dévient que très faiblement par rapport à leur axe nominal car toute déviation axiale d'un conducteur électrique de connexion 21 risque d'empêcher l'engagement dudit conducteur électrique de connexion 21 dans le trou de passage correspondant, ledit conducteur électrique de connexion 21 butant alors sur la surface de la carte électronique.

En effet, les conducteurs électriques de connexion 21 se présentent notamment sous la forme de fils électriques semi-rigides, généralement de section circulaire, ou de câbles composés de plusieurs brins conducteurs de section inférieure, s'étendant depuis une partie active du composant électrique 2 suivant un axe nominal, généralement vertical. Par rapport à leur axe nominal, théorique, généralement vertical, suivant lequel les conducteurs électriques de connexion 21 sont supposés s'étendre et sont donc attendus, ces derniers peuvent dévier axialement. Autrement dit, les conducteurs électriques de connexion 21 s'étendent depuis une partie active du composant électrique 2 théoriquement suivant leur axe nominal. Toutefois, par rapport audit axe nominal, du fait de leur souplesse relative, ils sont susceptibles de dévier. La déviation axiale possible des conducteurs électriques de connexion 21 est généralement limitée à un maximum de 2° correspondant, compte tenu de leur longueur, à un décalage maximal de leur extrémité libre de 2 mm. La déviation axiale maximale des conducteurs électriques de connexion 21 est ainsi prédéterminée, de même que le décalage maximal de leur extrémité libre.

En référence aux figures 2 à 4, en combinaison avec les figures 5 et 6, selon l'invention, on utilise des connecteurs électriques 3 ayant une partie de connexion 32 avec une surface de connexion 30 ayant une largeur très supérieure au diamètre des conducteurs électriques de connexion 21 destinés à être connectés par brasure auxdits connecteurs électriques 3, de sorte à ce que ladite largeur de la surface de connexion 30 soit supérieure audit décalage maximal de l'extrémité libre desdits conducteurs électriques de connexion 21, compte tenu de ladite déviation axiale maximale prédéterminée desdits conducteurs électriques de connexion 21. Il est entendu que la largeur de la surface de connexion 30 correspond à une dimension de ladite surface de connexion 30 dans une direction orthogonale à l'axe nominal selon lequel est supposé s'étendre le conducteur électrique de connexion 21.

Notamment, la partie de connexion 32 d'un connecteur électrique 3, selon l'invention, comprend une surface de connexion 30 présentant une largeur comprise entre 4mm et 6 mm pour un conducteur électrique de connexion 21 de 2 mm de diamètre. Plus spécifiquement, la largeur de la surface de connexion 30 de la partie de connexion 32 présente de préférence une largeur et une longueur comprises entre 1 fois et 5 fois le diamètre du conducteur électrique de connexion 21 destiné à être connecté par brasure audit connecteur électrique 3. De façon encore préférée, la largeur de la surface de connexion 30 de la partie de connexion 32 présente une largeur et une longueur comprises entre 2 fois et 3 fois le diamètre du conducteur électrique de connexion 21.

En pratique, comme le montre la figure 5 notamment, le conducteur électrique de connexion 21 doit simplement être amené, via l'ouverture de passage 11, à proximité de la surface de connexion 30 de la partie de connexion 32 du connecteur électrique 3. Puis le conducteur électrique de connexion 21 est brasé au contact de ladite surface de connexion 30. La surface de connexion 30 de la partie de connexion 32 est en outre adaptée pour permettre une brasure robuste du conducteur électrique de connexion 21, quelle que soit la déviation axiale dudit conducteur électrique de connexion 21.

En outre, comme le montre la figure 3 notamment, la largeur de la surface de connexion 30 de la partie de connexion 32 du connecteur électrique 3 est configurée pour se trouver en vis-à-vis du conducteur électrique de connexion 21 malgré la déviation axiale possible du conducteur électrique de connexion 21. Cela permet de rattraper un placement imparfait du conducteur électrique de connexion 21 du composant électrique 2.

L'ouverture de passage 11 présente des dimensions adaptées au passage de la partie de connexion 32 du connecteur électrique 3 et du conducteur électrique de connexion 21. En particulier, l'ouverture de passage 11 présente par conséquent une forme pouvant être sensiblement carrée, par exemple avec des bords arrondis, avec un côté ayant une dimension supérieure à la largeur de la partie de connexion 32 du connecteur électrique 3 et une deuxième dimension supérieure à la somme de l'épaisseur de la partie de connexion 32 et du diamètre du conducteur électrique de connexion 21. Notamment, la deuxième dimension de l'ouverture de passage 11 est au moins égale au double de cette somme. L'ouverture de passage 11 présente notamment des dimensions supérieures au décalage maximal de l'extrémité libre des conducteurs électriques de connexion 21, correspondant à la déviation axiale maximale des conducteurs électriques de connexion 21.

De façon préférée, comme représenté sur la figure 1, plusieurs ouvertures de passage 11 sont prévues sur la carte électronique 1.

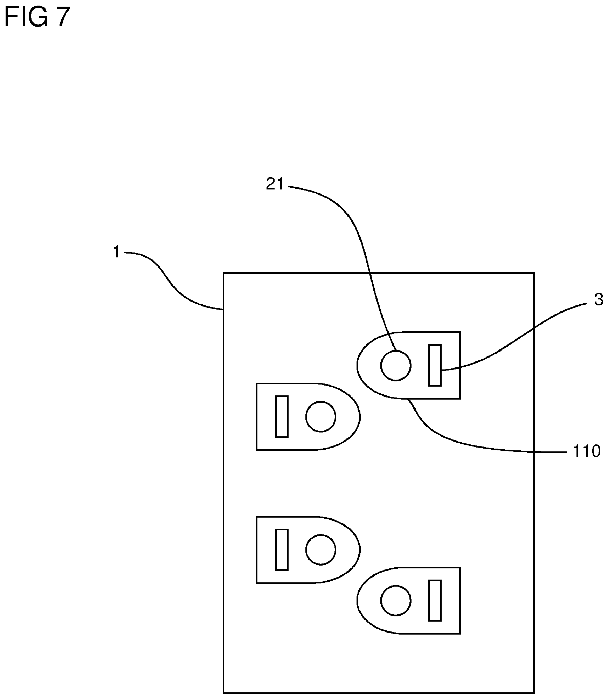

Selon un mode de réalisation encore préféré, représenté schématiquement sur la figure 7, on réalise sur la carte électronique 1 une ouverture de passage 110 dédiée pour chaque paire formée d'un connecteur électrique 3 et d'un conducteur électrique de connexion 21. En effet, dans un contexte, tel que dans le domaine des véhicules automobiles, où les équipements électriques considérés (convertisseurs de tension DC/DC, onduleurs, chargeurs électriques) transfèrent des puissances de plusieurs kilowatts, notamment des tensions supérieures à 300 V, il est avantageux de garantir un espacement, autrement désigné une distance d'isolation électrique de sécurité, suffisant entre les conducteurs électriques de connexion 21. Ceci peut être garanti par la mise en oeuvre d'ouvertures de passage 110 respectives pour chaque paire formée d'un connecteur électrique 3 et d'un conducteur électrique de connexion 21 du composant électrique 2. De la sorte, la localisation d'une ouverture de passage 110 impose la localisation du conducteur électrique de connexion 21 brasé sur la surface de connexion 30 de la partie de connexion 32 d'un connecteur électrique, la distance d'isolation électrique de sécurité entre conducteurs électriques de connexion 21 étant ainsi nativement garantie. Par exemple, la distance sur la carte électronique 1 entre deux bords les plus proches de deux ouvertures de passage 110 adjacentes peut être supérieure à une distance d'isolation électrique de sécurité prédéfinie, garantissant ainsi nativement le respect de ladite distance d'isolation électrique de sécurité entre les deux conducteurs électriques de connexion 21 correspondants.

Alternativement à la pluralité d'ouvertures de passage 110 espacées de sorte à garantir une distance d'isolation électrique de sécurité adéquate entre les conducteurs électriques de connexion 21, comme représenté sur la figure 7, on peut réaliser une grande ouverture de passage 11 par laquelle passent l'intégralité ou du moins une pluralité, comme sur la figure 1, de paires formées d'une partie de connexion 32 et d'un conducteur électrique de connexion 21. Cette alternative présente l'avantage de simplifier le procédé de fabrication de l'ensemble électrique selon l'invention, bien que cela impose, en revanche, un positionnement moins libre des conducteurs électriques de connexion 21, ceux-ci devant être proches de leur position axiale théorique et ayant par conséquent une localisation moins précisément imposée. Toutefois, cette alternative reste avantageuse par rapport à l'état de l'art car l'utilisation de connecteurs électriques 3 ayant des parties de connexion 32 larges permet de rattraper dans une certaine mesure une déviation axiale des conducteurs électriques de connexion 21.

## Revendications

1. Ensemble électrique comprenant une carte électronique (1), au moins un connecteur électrique (3) et un composant électrique (2), ledit connecteur électrique (3) étant rapporté sur la carte électronique (1) pour y connecter le composant électrique (2), le connecteur électrique (3) comprenant une partie de montage (31) et une partie de connexion (32), le composant électrique (2) comprenant au moins un conducteur électrique de connexion (21) dont une extrémité est connectée à une partie active du composant électrique (2) et l'autre extrémité est libre et destinée à être connectée au connecteur électrique (3), **caractérisé en ce que** la carte électronique (1) ayant une ouverture de passage (11) permettant le passage d'une partie du conducteur électrique de connexion (21) comprenant l'extrémité libre et de la partie de connexion (32) du connecteur électrique (3), ledit conducteur électrique de connexion (21) s'étendant et traversant l'ouverture de passage (11) suivant un axe réel présentant, par rapport à un axe nominal selon lequel ledit conducteur électrique de connexion (21) est supposé s'étendre, ayant une déviation axiale inférieure à une déviation axiale maximale prédéterminée, la partie de connexion (32) du connecteur électrique (3) présentant une surface de connexion (30) configurée pour recevoir l'extrémité libre du conducteur électrique de connexion (21), la surface de connexion (30) ayant une largeur supérieure à un décalage maximal de l'extrémité libre du conducteur électrique de connexion (21) correspondant à ladite déviation axiale maximale prédéterminée du conducteur électrique de connexion (21).

2. Ensemble électrique selon la revendication 1, dans lequel le connecteur électrique (3) présente une section formant un angle droit et comprend une partie de montage (31), correspondant à ladite partie de montage, parallèle à la carte électronique (1) et une partie de connexion (32) orthogonale au plan de la carte électronique, ledit connecteur électrique (3) étant rapporté sur la carte électronique (1) de telle sorte que la partie de montage (31) se trouve d'un côté de la carte électronique (1), du même côté que la partie active du composant électrique (2) ou de l'autre côté, et la partie de connexion (32) traverse la carte électronique (1) via l'ouverture de passage (11), la connexion entre l'extrémité libre du conducteur électrique de connexion (21) et la surface de connexion (30) de la partie de connexion (32) étant destinée à être réalisée du côté opposé de la carte électronique (1).

3. Ensemble électrique selon la revendication 1 ou 2, dans lequel le conducteur électrique de connexion (21) est brasé sur la surface de connexion (30) du connecteur électrique (3).

4. Ensemble électrique selon l'une quelconque des revendications 1 à 3, dans lequel le composant électrique (2) est un transformateur électrique.

5. Ensemble électrique selon la revendication 4, dans lequel ledit connecteur électrique (3) est adapté pour recevoir la connexion du conducteur électrique de connexion (21), ledit conducteur électrique de connexion (21) étant destiné à transférer une haute tension, supérieure à 300 V.

6. Ensemble électrique selon l'une quelconque des revendications précédentes, dans lequel la carte électronique (1) est une carte de commande d'un équipement électrique.

7. Ensemble électrique selon l'une quelconque des revendications précédentes, comprenant au moins deux connecteurs électriques (3), et dans lequel la carte électronique (1) comporte une unique ouverture de passage permettant le passage d'au moins deux conducteurs électriques de connexion (21) du composant électrique (2) et des au moins deux parties de connexion (32) correspondantes.

8. Ensemble électrique selon l'une quelconque des revendications 1 à 6, comprenant au moins deux connecteurs électriques (3), et dans lequel la carte électronique (1) comporte au moins deux ouvertures de passage (110) permettant respectivement le passage d'un conducteur électrique de connexion (21) du composant électrique (2) et d'une partie de connexion (32) correspondante d'un connecteur électrique (3), le nombre d'ouvertures de passage (110) étant adapté au nombre de paires formées d'un conducteur électrique de connexion (21) et d'un connecteur électrique (3).

9. Ensemble électrique selon la revendication 8, présentant un espacement entre ouvertures de passage (110) supérieur à une distance d'isolation électrique de sécurité prédéfinie.

10. Equipement électrique comprenant un ensemble électrique selon l'une des revendications précédentes, ledit équipement électrique étant un convertisseur de tension DC/DC ou un onduleur ou un chargeur électrique.

## Patentansprüche

1. Elektrische Anordnung, umfassend eine elektronische Karte (1), mindestens einen elektrischen Steckverbinder (3) und ein elektrisches Bauelement (2), wobei der elektrische Steckverbinder (3) auf die elektronische Karte (1) aufgesetzt ist, um das elektrische Bauelement (2) damit zu verbinden, wobei der elektrische Steckverbinder (3) einen Montageteil (31) und einen Anschlussteil (32) umfasst, wobei das elektrische Bauelement (2) mindestens einen elektrischen Anschlussleiter (21) umfasst, dessen eines Ende mit einem aktiven Teil des elektrischen Bauelements (2) verbunden ist und dessen anderes Ende frei ist und dazu bestimmt ist, mit dem elektrischen Steckverbinder (3) verbunden zu werden, **dadurch gekennzeichnet, dass** die elektronische Karte (1) eine Durchgangsöffnung (11) hat, die den Durchgang eines Teils des elektrischen Anschlussleiters (21), der das freie Ende umfasst, und des Anschlussteils (32) des elektrischen Steckverbinders (3) ermöglicht, wobei sich der elektrische Anschlussleiter (21) entlang einer realen Achse erstreckt und die Durchgangsöffnung (11) durchquert, die in Bezug auf eine Nennachse, entlang der sich der elektrische Anschlussleiter (21) angenommenerweise erstreckt, eine axiale Abweichung aufweist, die geringer als eine vorbestimmte maximale axiale Abweichung ist, wobei der Anschlussteil (32) des elektrischen Steckverbinders (3) eine Anschlussfläche (30) aufweist, die dazu ausgestaltet ist, das freie Ende des elektrischen Anschlussleiters (21) aufzunehmen, wobei die Anschlussfläche (30) eine Breite hat, die größer als ein maximaler Versatz des freien Endes des elektrischen Anschlussleiters (21) ist, der der vorbestimmten maximalen axialen Abweichung des elektrischen Anschlussleiters (21) entspricht.

2. Elektrische Anordnung nach Anspruch 1, bei welcher der elektrische Steckverbinder (3) einen Abschnitt aufweist, der einen rechten Winkel bildet, und einen Montageteil (31), der dem Montageteil entspricht, parallel zu der elektronischen Karte (1) und einen Anschlussteil (32) senkrecht zur Ebene der elektronischen Karte umfasst, wobei der elektrische Steckverbinder (3) auf die elektronische Karte (1) so aufgesetzt ist, dass sich der Montageteil (31) auf einer Seite der elektronischen Karte (1), auf derselben Seite wie der aktive Teil des elektrischen Bauelements (2), oder auf der anderen Seite befindet und der Anschlussteil (32) die elektronische Karte (1) durch die Durchgangsöffnung (11) durchquert, wobei der Anschluss zwischen dem freien Ende des elektrischen Anschlussleiters (21) und der Anschlussfläche (30) des Anschlussteils (32) dazu bestimmt ist, auf der entgegengesetzten Seite der elektronischen Karte (1) ausgeführt zu werden.

3. Elektrische Anordnung nach Anspruch 1 oder 2, bei welcher der elektrische Anschlussleiter (21) an die Anschlussfläche (30) des elektrischen Steckverbinders (3) gelötet ist.

4. Elektrische Anordnung nach einem der Ansprüche 1 bis 3, bei der das elektrische Bauelement (2) ein elektrischer Transformator ist.

5. Elektrische Anordnung nach Anspruch 4, bei welcher der elektrische Steckverbinder (3) angepasst ist, um den Anschluss des elektrischen Anschlussleiters (21) aufzunehmen, wobei der elektrische Anschlussleiter (21) dazu bestimmt ist, eine hohe Spannung von mehr als 300 V zu übertragen.

6. Elektrische Anordnung nach einem der vorhergehenden Ansprüche, bei der die elektronische Karte (1) eine Steuerkarte eines elektrischen Geräts ist.

7. Elektrische Anordnung nach einem der vorhergehenden Ansprüche, die mindestens zwei elektrische Steckverbinder (3) umfasst und bei der die elektronische Karte (1) eine einzige Durchgangsöffnung beinhaltet, die den Durchgang von mindestens zwei elektrischen Anschlussleitern (21) des elektrischen Bauelements (2) und der mindestens zwei Anschlussteile entsprechenden (32) ermöglicht.

8. Elektrische Anordnung nach einem der Ansprüche 1 bis 6, die mindestens zwei elektrische Steckverbinder (3) umfasst und bei der die elektronische Karte (1) mindestens zwei Durchgangsöffnungen (110) beinhaltet, die jeweils den Durchgang eines elektrischen Anschlussleiters (21) des elektrischen Bauelements (2) und eines entsprechenden Anschlussteils (32) eines elektrischen Steckverbinders (3) ermöglichen, wobei die Anzahl von Durchgangsöffnungen (110) an die Anzahl von Paaren, die aus einem elektrischen Anschlussleiter (21) und einem elektrischen Steckverbinder (3) gebildet werden, angepasst ist.

9. Elektrische Anordnung nach Anspruch 8, die einen Abstand zwischen Durchgangsöffnungen (110) aufweist, der größer als eine vorgegebene elektrische Sicherheitsisolationsstrecke ist.

10. Elektrisches Gerät, das eine elektrische Anordnung nach einem der vorhergehenden Ansprüche umfasst, wobei das elektrische Gerät ein DC/DC-Spannungswandler oder ein Wechselrichter oder ein elektrisches Ladegerät ist.

## Claims

1. Electrical assembly comprising an electronic board (1), at least one electrical connector (3) and an electrical component (2), said electrical connector (3) being attached to the electronic board (1) so as to connect the electrical component (2) thereto, the electrical connector (3) comprising a fitting part (31) and a connecting part (32), the electrical component (2) comprising at least one electrical connection conductor (21), one end of which is connected to an active part of the electrical component (2) and the other end of which is free and intended to be connected to the electrical connector (3), **characterized in that** the electronic board (1) has a through-opening (11) allowing a part of the electrical connection conductor (21) comprising the free end and the connecting part (32) of the electrical connector (3) to pass through, said electrical connection conductor (21) extending and passing through the through-opening (11) along a real axis having, in comparison to a nominal axis along which said electrical connection conductor (21) is supposed to extend, an axial deviation that is less than a predetermined maximum axial deviation, the connecting part (32) of the electrical connector (3) having a connection surface (30) that is configured to receive the free end of the electrical connection conductor (21), the connection surface (30) having a width larger than a maximum offset of the free end of the electrical connection conductor (21) corresponding to said predetermined maximum axial deviation of the electrical connection conductor (21).

2. Electrical assembly according to Claim 1, wherein the electrical connector (3) has a section forming a right angle and comprises a fitting part (31), corresponding to said fitting part, which is parallel to the electronic board (1) and a connecting part (32) which is orthogonal to the plane of the electronic board, said electrical connector (3) being attached to the electronic board (1) in such a way that the fitting part (31) is located on one side of the electronic board (1), on the same side as the active part of the electrical component (2) or on the other side, and the connecting part (32) passes through the electronic board (1) via the through-opening (11), the free end of the electrical connection conductor (21) and the connection surface (30) of the connecting part (32) being intended to be connected to one another on the opposite side of the electronic board (1) .

3. Electrical assembly according to Claim 1 or 2, wherein the electrical connection conductor (21) is brazed to the connection surface (30) of the electrical connector (3).

4. Electrical assembly according to any one of Claims 1 to 3, wherein the electrical component (2) is an electrical transformer.

5. Electrical assembly according to Claim 4, wherein said electrical connector (3) is designed to receive the connection of the electrical connection conductor (21), said electrical connection conductor (21) being intended to transfer a high voltage of greater than 300 V.

6. Electrical assembly according to any one of the preceding claims, wherein the electronic board (1) is a control board of an item of electrical equipment.

7. Electrical assembly according to any one of the preceding claims, comprising at least two electrical connectors (3), and wherein the electronic board (1) comprises a single through-opening allowing at least two electrical connection conductors (21) of the electrical component (2) and the at least two corresponding connecting parts (32) to pass through.

8. Electrical assembly according to any one of Claims 1 to 6, comprising at least two electrical connectors (3), and wherein the electronic board (1) comprises at least two through-openings (110) allowing an electrical connection conductor (21) of the electrical component (2) and a corresponding connecting part (32) of an electrical connector(3), respectively, to pass through, the number of through-openings (110) being matched to the number of pairs formed of an electrical connection conductor (21) and an electrical connector (3).

9. Electrical assembly according to Claim 8, having a spacing between through-openings (110) that is greater than a predefined safety electrical insulation distance.

10. Item of electrical equipment comprising an electrical assembly according to one of the preceding claims, said item of electrical equipment being a DC/DC voltage converter or an inverter or an electrical charger.
